# EUROPEAN PATENT SPECIFICATION

(11) **EP 1 664 396 B1**
(45) Date of publication and mention of the grant of the patent: **14.09.2011**
(21) Application number: 04763149.4
(22) Date of filing: 07.07.2004
(51) Int. Cl.: C30B 25/02, H01L 21/762, C30B 33/00

(54) **A METHOD OF FABRICATING AN EPITAXIALLY GROWN LAYER**
VERFAHREN ZUR HERSTELLUNG EINER EPITAKTISCH AUFGEWACHSENEN SCHICHT
PROCEDE DE FABRICATION D'UNE COUCHE DE CROISSANCE EPITAXIALE

(30) Priority: 24.07.2003 FR 0309076
(43) Date of publication of application: 07.06.2006
(73) Proprietor: S.O.I.Tec Silicon on Insulator Technologies, 38190 Bernin (FR)
(72) Inventor: FAURE, Bruce, F-38000 Grenoble (FR); DI CIOCCIO, Léa, F-38330 Saint-Ismier (FR)
(74) Representative: Bomer, Françoise Marie
(86) International application number: PCT/EP2004/007577
(87) International publication number: WO 2005/014895

(56) References cited:
- EP-A- 1 288 346
- WO-A-01/75196
- WO-A-02/43112
- WO-A-02/43124
- US-A- 6 146 457
- US-B1- 6 303 468
- US-B1- 6 335 263
- US-B1- 6 391 799
- BALKAS C M ET AL: "Growth and characterization of GaN single crystals" JOURNAL OF CRYSTAL GROWTH, NORTH-HOLLAND PUBLISHING CO. AMSTERDAM, NL, vol. 208, no. 1-4, 1 January 2000 (2000-01-01), pages 100-106, XP004253381 ISSN: 0022-0248 cited in the application
- POROWSKI S: "Bulk and homoepitaxial GaN-growth and characterisation" JOURNAL OF CRYSTAL GROWTH, NORTH-HOLLAND PUBLISHING, AMSTERDAM, NL, vol. 189-190, 15 June 1998 (1998-06-15), pages 153-158, XP004148494 ISSN: 0022-0248 cited in the application

## Description

The present invention relates to a method of fabricating an epitaxially grown layer, i.e. a layer obtained by epitaxy, intended in particular for applications in the fields of optics, optoelectronics, or electronics.

Certain materials, for example silicon, having properties that are particularly interesting in the fields mentioned above, can be obtained in large quantities and with excellent quality using ingot pulling techniques that are well known to the skilled person.

The ingots obtained are then readily sliced into wafers which, after a large number of processing steps, become substrates that are used to produce integrated circuits, for example.

Other materials such as gallium arsenide, gallium nitride, indium phosphide, germanium, or silicon carbide, are also of interest. However, not all of those materials can be obtained by pulling ingots of high crystalline quality. Further, it is not always possible to fabricate substrates from such ingots because the costs are too high or the method is too difficult to implement.

Thus, for example, no method currently exists for fabricating gallium nitride (GaN) ingots on an industrial scale.

The document "Bulk and homoepitaxial GaN growth and characterization", Porowski-S, Journal of Crystal Growth, vol 189-190, June 1998, pp. 153-158, describes a method of growing a monocrystalline GaN ingot in the liquid phase at a pressure of 12 to 20 kbars (12 to 20 × 10⁸ Pascals (Pa)) and at a temperature in the range 1400°C to 1700°C. However, those conditions are difficult to implement under mass production conditions. Further, they can only produce crystals with a maximum diameter of 18 millimeters (mm).

Other research teams have also worked on a method of growing an ingot in the liquid phase at reduced pressure (less than 2 bars (2 × 10⁵ Pa)) and at a temperature of 1000°C. The diameter of the crystals obtained is larger, close to 50 mm, but the crystalline quality obtained is not as good as with the above-mentioned technique.

Finally, the document "Growth and characterization of GaN single crystals", Balka et al, Journal of Crystal Growth, vol 208, January 2000, p 100-106, discloses the growth of monocrystalline GaN by sublimation. The fabrication conditions employed are a pressure of less than 1 bar ((10⁵ Pa) and a temperature of 1000°C to 1200°C. The crystalline quality obtained is very high, but the crystal size is 3 mm, which is clearly insufficient for the envisaged applications.

Thus, the market currently offers no monocrystalline gallium nitride in the bulk form, of high quality, of a sufficient diameter, and at a reasonable price.

The prior art discloses a number of attempts to fabricate substrates by epitaxy or heteroepitaxy in order to overcome the problem of obtaining certain specific materials.

Epitaxy can combine materials with different natures in the form of thin films and combine their properties to produce components, for example high electron mobility transistors (HEMTs), diodes, or lasers.

Heteroepitaxy consists of depositing the desired material onto a support of different crystallographic nature by epitaxy, and then eliminating the support, if possible and necessary for the remainder of the process.

The main drawback of that technique is that the material constituting the support and that deposited by epitaxy generally have different lattice parameters and thermal expansion coefficients.

The differences in lattice parameters between the support and the epitaxial layer create a large number of crystalline defects in the epitaxially grown material, such as dislocations or stacking defects, for example.

Added to that is the fact that epitaxial growth is generally carried out at high temperatures, above 600°C and possibly up to 1000°C to 1100°C, for example, when growing gallium nitride epitaxially by metal organic chemical vapor deposition (MOCVD). For that reason, as the structure which is formed cools to ambient temperature, the epitaxial layer obtained develops a number of residual stresses and strains connected with differences in thermal expansion between it and its support.

To overcome that drawback, the material selected as the support preferably has crystalline structure and thermal expansion coefficient very close to those of the materials which are to be grown epitaxially. As an example, gallium and indium arsenide or gallium and aluminum arsenide can be grown epitaxially on a gallium arsenide support with crystallographic quality that is sufficient to produce components.

However, other materials do not always have a compatible support that is in the form of a substrate. This is particularly the case with materials such as gallium nitride or cubic silicon carbide.

Until now, components having one of those two materials as the active layer have been grown by heteroepitaxy.

Thus, for gallium nitride, light-emitting diodes (LEDs) and lasers emitting in the blue, violet and ultraviolet as well as high frequency power components have been produced using sapphire, hexagonal silicon carbide, or silicon as the support.

For silicon carbide, which is unavailable in the form of a substrate in its cubic crystalline structure, micro electromechanical components (MEMS) or power transistors have been produced by depositing silicon carbide onto a silicon substrate by epitaxy.

However, in order to further improve the quality of the components obtained, it would be desirable to fabricate bulk gallium nitride or cubic silicon carbide substrates of the same nature as the epitaxially grown layer deposited over it.

Attempts made in the past have all resulted in products with a certain number of disadvantages.

As an example, one intermediate route consists in using a technique termed "high growth rate epitaxy" to produce an epitaxially grown film that is as thick as the substrate supporting it. That support substrate is then eliminated and only the thick epitaxially grown film is retained, which in turn becomes a substrate for conventional epitaxy. Methods of that type exist for producing gallium nitride and silicon carbide, but the quality of the substrates obtained is generally mediocre because of the influence of the original support substrate of different crystallographic nature.

Thus, typically, large residual stresses are observed in the case of the epitaxial growth of cubic silicon carbide on silicon. Such stresses generally result in very substantial curvature of the epitaxially grown silicon carbide once the original silicon support substrate has been removed. That curvature renders it unusable for all subsequent forming steps.

Similarly, for the gallium nitride obtained, the influence of the support substrate is illustrated by the appearance of a very large number of dislocations and by cracking of the epitaxially grown film as its temperature falls, in particular when that epitaxially grown film exceeds a certain critical thickness.

United States patent No. 6 146 457 describes a further method that makes use of the stresses that appear as the temperature falls following epitaxy as the driving force for detaching an original support substrate from a thick epitaxially grown layer. That result is obtained by inserting a layer termed a "weak" layer between the support substrate and the thick epitaxially grown layer such that when the system stresses increase (as happens during cooling), the weak layer ruptures naturally and thus ensures controlled detachment of the support from the thick epitaxial layer. However, that detachment technique is difficult to control with a large specimen. Further, it involves inserting a particular layer as epitaxial growth commences or during epitaxial growth, which may be deleterious to the crystallographic quality of that epitaxially grown layer.

US-6,303,468 relates to a method of manufacturing a thin film of solid material. According to this process, an ionic implantation through one face of a substrate of said solid material is done, followed by an annealing step carried out with a specific thermal budget in order to obtain the cleavage of this substrate. According to one embodiment, this process may be applied to a substrate that includes a layer obtained by epitaxial growth.

Further, the document "Physical properties of bulk GaN crystals grown by HVPE", Melnik et al, MRS Internet Journal of Nitride Semiconductor Research, vol 2, art 39, describes a method of growing gallium nitride (GaN) monocrystals by HVPE on a monocrystalline silicon carbide (SiC) substrate, and removing that substrate using a reactive ionic etching (RIE) technique. However, that SiC substrate takes a long time to remove since it is highly inert chemically.

Finally, the document "Large free-standing GaN substrates by hydride vapor phase epitaxy and laser induced lift-off", Kelly et al, Jpn J Appl Phys, vol 38, 1999, describes a method of growing GaN by hydride vapor phase epitaxy (HVPE) on a sapphire substrate, then removing that substrate by laser-induced lift-off. That technique is based on using a laser of a wavelength that is absorbed only by gallium nitride and not by sapphire. Scanning the resulting structure with the laser ensures that the two materials become detached by local modification of the properties of the GaN after passage of the laser.

However, that lift-off technique is difficult to implement when treating large areas, since laser beam scanning takes a long time. It is also possible to remove the sapphire substrate by mechanical polishing, but that method is also lengthy and furthermore, it runs the risk of breaking the gallium nitride layer when lifting off the substrate, by releasing the existing stresses.

The invention aims to overcome the disadvantages of the prior art cited above and to provide a method of fabricating an epitaxially grown layer of excellent crystallographic quality that can readily be detached from its epitaxy support.

More particularly, the invention is applicable to all materials which have previously been obtainable only by heteroepitaxy, in particular wide band gap materials.

The invention also aims to provide an epitaxy support substrate and a method for its fabrication.

To this end, the invention provides a method as set forth in of claim 1 fabricating an epitaxially grown layer in particular for applications in the fields of optics, optoelectronics, or electronics.

Said method is characterized in that it comprises the following steps consisting in:
a) implanting atomic species within a first substrate termed the "support substrate" to define therein a zone of weakness which demarcates a thin layer termed the "thin support layer" from the remainder of said substrate;
b) growing said epitaxialy grown layer by epitaxy carried out on a thin nucleation layer of a nature which is suitable for said expitaxial growth, said thin nucleation having been transferred onto the thin support layer ;
c) detaching the remainder of the support substrate from the thin support layer along the zone of weakness of said support substrate by deliberately supplying an energy budget greater than the cumulative energy budget supplied during all of the steps preceding said detachment.

That method overcomes the problem of eliminating the support substrate; such a step can be difficult to implement, as mentioned above in the analysis of the prior art. As an example, eliminating hard materials such as sapphire or silicon carbide is lengthy and difficult using conventional lapping or chemical or ionic etching techniques.

According to a first embodiment, said thin nucleation layer is transferred:
- by implanting atomic species within a second substrate termed the "nucleation substrate" to define therein a zone of weakness which demarcates said thin nucleation layer from the remainder of said substrate, then
- by bonding the two substrates either directly one against the other, or using at least one intermediate bonding layer so that their respective thin layers are located facing each other, and
- by detaching the remainder of the nucleation substrate along the zone of weakness of said substrate;
the parameters for implantation into the support substrate and into the nucleation substrate being selected so that when combined with the nature of the materials constituting said two substrates, the energy budget to be supplied during detachment of the remainder along the zone of weakness is greater than the cumulative energy budget supplied during all of the steps preceding detachment.

Advantageously, the parameters for implantation into the support substrate and into the nucleation substrate are selected so that, when combined with the nature of the materials constituting said two substrates, the thermal budget to be supplied during detachment of the remainder along the zone of weakness is greater than the cumulative thermal budget supplied during all of the steps preceding said detachment, and the steps for detaching the two remainders are carried out by heating.

Further, said method can produce an epitaxially grown layer of excellent crystallographic quality by using the nucleation layer having lattice parameters and thermal expansion coefficient value that are well suited to subsequent epitaxy.

Finally, this method can combine a support substrate with a thermal expansion coefficient close to that of the epitaxially grown layer with a nucleation layer of crystalline structure that is close to that of said epitaxially grown layer. This is not possible if a simple substrate is used instead of a hybrid substrate as in the invention. Such a "hybrid" substrate can simultaneously improve the crystalline quality of the resulting epitaxially grown layer and can limit residual stresses in said layer.

The method also presents the following advantageous and non-limiting characteristics, taken in isolation or in combination.

Advantageously, the remainder of the nucleation substrate or the remainder of the support substrate is detached by application of additional energy of mechanical, optical, and/or chemical origin.

According to a second embodiment said thin nucleation layer is transferred:
- by bonding a second substrate, termed the "nucleation substrate" either directly onto said thin support layer, or using at least one intermediate bonding layer,
- by reducing the thickness of said substrate from its back face by lapping and/or chemical etching and/or ionic etching to obtain said thin nucleation layer.

Preferably, said intermediate bonding layer is a layer of dielectric material, such as silicon oxide, silicon nitride, and silicon oxynitrides.

Advantageously, bonding between the two thin layers either directly one against the other or in the presence of at least one intermediate bonding layer is molecular bonding.

Said interposed layer may be a fine nucleation layer formed on said thin support layer or on said thin nucleation layer.

Preferably, the epitaxially grown layer is produced from a wide band gap semiconductor material.

The epitaxially grown layer may be of sufficient thickness to constitute a self-supported layer or insufficient to be self-supporting. In this last case, and the method comprises the following additional steps carried out between steps b) and c) and consisting in:
- applying a first layer of metal onto said thin epitaxial layer and a second layer of metal onto a third substrate termed the "acceptor substrate";
- placing the two layers of metal in contact with each other and bonding them together;
to obtain the thin epitaxial layer transferred onto said acceptor substrate.

According to an other embodiment, the support substrate comprises an upper template layer and the atomic species implantation is carried out either within said support substrate through said upper template layer or inside said upper template layer, the parameters for implantation carried out in the support substrate or in the template layer being selected such that when combined with the nature of the materials constituting said substrate and said template layer, the energy budget to be supplied during detachment of the remainder along the zone of weakness is greater than the cumulative energy budget supplied during all of the steps preceding said detachment.

Finally, the invention relates to an epitaxy support substrate which comprises at least:
- a first substrate termed "support substrate" comprising a zone of weakness which demarcates a thin layer termed the "thin support layer" from the remainder of said substrate, and
- a thin nucleation layer the nature of which is suitable for subsequent epitaxial growth of said epitaxially grown layer, said nucleation layer being bonded to said support film either directly or by means of at least one layer of intermediate bonding material, such as a dielectric material.

The invention also relates to a method of fabricating such a substrate, which comprises the following steps consisting in:
i) implanting atomic species within a first substrate (1, 1') termed the "support substrate" to define therein a zone of weakness (12, 12') which demarcates a thin layer (13, 13') termed the "thin support layer" from the remainder (11, 11') of said substrate;
ii) implanting atomic species within a second substrate (2) termed the "support substrate" to define therein a zone of weakness (22) which demarcates said thin nucleation layer (23) from the remainder (21) of said substrate,
iii) bonding the two substrates (1, 2) either directly one against the other, or using at least one intermediate bonding layer (31, 32) so that their respective thin layers (13, 23) are located facing each other; and
iv) detaching the remainder (21) of the nucleation substrate (2) along the zone of weakness (22) of said substrate (2);
the parameters for implantation into the support substrate (1) and into the nucleation substrate (2) being selected so that when combined with the nature of the materials constituting said two substrates, the energy budget to be supplied later for detaching the remainder (11) along the zone of weakness (12, 12') is greater than the cumulative energy budget supplied during all of the steps preceding detachment.

Other characteristics and advantages of the invention become apparent from the following description made with reference to the accompanying drawings which provide non-limiting indications of possible implementations.

In the drawings:
- Figures 1 to 8 are diagrams representing the different successive steps of a first implementation of the method of the invention;
- Figures 9 to 13 are diagrams representing the different successive steps of a second implementation of the method; and
- Figures 14 to 17 and 18 to 22 are diagrams representing the different successive steps of a third and fourth implementation of the method.

It should be noted that for simplification, the different layers shown in the figures are not drawn to scale particularly as regards their relative thicknesses.

The method of the invention uses a first substrate 1 termed the "support substrate" and a second substrate 2 termed the "nucleation substrate".

The support substrate 1 has a face 130 termed the "front face" intended to come into contact subsequently with the nucleation substrate 2 or to serve directly as the nucleation layer for subsequent epitaxy, as is described below in a further implementation, and an opposite face 110 termed the "back face".

Similarly, the nucleation substrate 2 has a front face 230 and an opposite back face 210.

The material constituting the support substrate 1 is selected to have good mechanical strength even at high temperatures which may reach 1300°C to 1400°C. It is also selected as a function of the nature of the material constituting the nucleation substrate 2, as will be described below. Advantageously, currently commercially available bulk substrates are used.

Purely by way of illustration, it is possible to mention silicon, sapphire, polycrystalline silicon carbide, 6H or 4H monocrystalline silicon carbide, gallium nitride (GaN), aluminum nitride (AlN), and zinc oxide (ZnO).

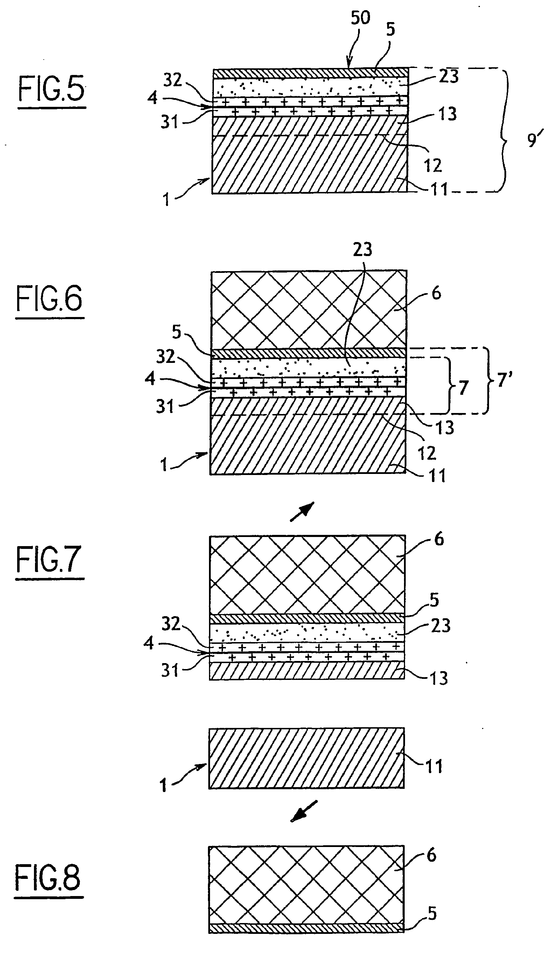

The nucleation substrate 2 is selected so that its nature and its lattice parameters allow subsequent epitaxial growth of the future layer of epitaxially grown material which is to be obtained and which has the reference numeral 6 or 6' (see Figures 7 to 9 and 10 to 14).

As an example, the nucleation substrate 2 can be a semiconductor material such as gallium nitride (GaN), silicon (Si), silicon carbide (SiC), sapphire, diamond, gallium arsenide (AsGa), or aluminum nitride (AlN). However, this list is not limiting.

When an epitaxially grown layer of gallium nitride is to be formed, said nucleation substrate 2 is preferably selected from (111) silicon, silicon carbide (SiC), sapphire, or gallium nitride (GaN), and when the epitaxial layer is formed from cubic silicon carbide, the nucleation substrate 2 is preferably (001) silicon Si, or silicon carbide.

The two substrates 1 and 2 can be of identical or different natures.

An operation for implanting atomic species in the support substrate 1 and in the nucleation substrate 2 is then carried out, preferably on their respective front faces 130 and 230.

The term "atomic species implantation" means any bombardment of atomic, molecular, or ionic species which can introduce said species into a material with a maximum concentration of said species located at a depth that is determined with respect to the bombarded surface, in this case the surfaces 130 or 230. The molecular or ionic atomic species are introduced into the material with an energy that is also distributed about a maximum.

Atomic species implantation can be carried out, for example, using an ion beam implanter or a plasma immersion implanter.

Preferably, said implantation is carried out by ionic bombardment. Preferably, the implanted ionic species is hydrogen. Other ionic species can advantageously be used alone or in combination with hydrogen, such as rare gases (for example helium).

Reference should be made in this regard to the literature concerning the method known under the registered trade mark "Smart Cut".

Said implantation creates a zone of weakness 12 in the bulk of the source substrate 1 at a mean ion penetration depth. It divides the substrate 1 into two portions, namely a thin layer 13 termed below the "thin support layer" and the remainder 11 of said substrate.

The thin layer 13 extends between the zone of weakness 12 and its front face 130.

In similar manner, following implantation, the nucleation substrate 2 has a zone of weakness 22, a thin nucleation layer 23, and a remainder 21.

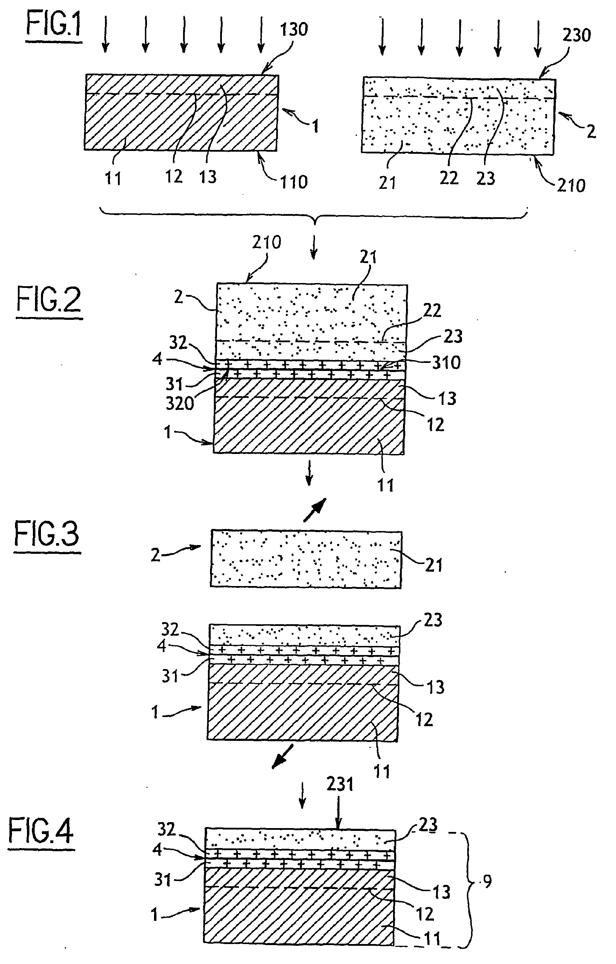

Optionally, and not shown in Figure 1, it is possible to form a layer of protective material on the front layer 130 of the substrate 1 and/or on the front face 230 of the substrate 2.

When such protective layers are present, atomic species implantation can be carried out through them, in particular by implantation over their respective free upper faces. Said layers may be sacrificial layers which act as masks and thus protect the substrates 1 and 2 during implantation. They can thus be eliminated after said implantation.

The parameters for the two atomic species implantations, i.e. the dose and the implantation energy, are selected as a function of the detailed criteria given below.

As shown in Figure 2, the support substrate 1 is then bonded onto the nucleation substrate 2 such that their respective thin layers 13 and 23 are located facing each other.

Advantageously, bonding is carried out by molecular bonding. Such bonding techniques are known to the skilled person and have been described, for example, in the work by Gösele, "Semiconductor wafer bonding", Sciences and Technology, Q.Y. Tong, U. Gösele, Wiley Interscience publications.

The bonding interface between the front face 130 of the support substrate 1 and the front face 230 of the support substrate 2 carries reference numeral 4.

However, it is also possible to carry out bonding between the thin layers 13 and 23 by means of at least one intermediate bonding layer formed on the front layer 130 of the substrate 1 and/or on the front face 230 of the substrate 2. Said layers can, for example, be the above-mentioned layers for protection during implantation or specific layers termed "bonding boosting layers" and carrying reference numerals 31 and 32. The bonding interface 4 is then the interface between the upper face 310 of the layer of material 31 and the upper face 320 of the layer of material 32.

As an example, said layers of material 31 and 32 can be formed from amorphous or polycrystalline silicon or from alumina (Al₂O₃).

Advantageously, said bonding boosting layers 31 and 32 can be layers of dielectric material selected, for example, from silicon oxide (SiO₂), silicon nitride (Si₃N₄), or silicon oxynitrides (SiₓO_{y}N). They may be identical in nature or different, and they have thickness in the range from a few tens of nanometers to about 1 micrometer (1 µm).

Said layers 31 and 32 can, for example, be obtained by plasma enhanced chemical vapor deposition, (PECVD) or by oxidation of the substrate when it is formed from silicon or monocrystalline silicon carbide.

The two contacting surfaces are bonded after suitable surface preparation, for example and as is well known to the skilled person, by cleaning in known SC1 or SC2 type chemicals, by chemico-mechanical polishing, or by plasma or ultraviolet-ozone activation of one or both contacting surfaces. Ultraviolet-ozone activation is exposure to ultraviolet radiation in a gas environment so that the ultraviolet radiation interacts with the environment and generates ozone which then activates the surface. These various methods can also be combined.

The abbreviation "SC" corresponds to "standard clean". Cleaning product SC1 is based on liquid ammonia, hydrogen peroxide, and water, and SC2 is based on hydrochloric acid, hydrogen peroxide, and water.

Bonding can also be reinforced by thermal annealing. This annealing is adapted so that it has no influence on the zones of weakness 12 and 22 and does not cause detachment along those zones at this stage.

The aim of said treatment is to obtain strong bonding at the bonding interface 4 and to provide a "stiffening" effect which maintains the growth of defects formed at the zones of weakness 12 and 22 in a plane parallel to that of said bonding interface 4.

The remainder 21 of the nucleation substrate 2 shown in Figure 3 can then be detached by supplying energy of mechanical, thermal, optical, and/or chemical origin.

In this regard, it should be noted that the two above-mentioned atomic species implantation steps are carried out with dose and implantation energy parameters selected such that, combined with the nature of the pair of materials constituting the support substrate 1 and the nucleation substrate 2, the energy budget to be supplied to carry out subsequent detachment of the remainder 11 along the zone of weakness 12 is greater than the cumulative energy budget supplied during all of the steps preceding detachment.

Advantageously, said parameters are selected so that the thermal budget to be supplied during detachment of the remainder 11 along the zone of weakness 12 is greater than the cumulative thermal budget supplied during all of the steps preceding said detachment and the steps for detaching the remainder 11 and the remainder 21 are carried out by heating.

Further, it should be noted that the strength of the bonding interface 4 is sufficient to tolerate said two detachments without unbonding.

Energy of thermal origin can be supplied by applying a suitable thermal budget, for example by heating the stack of layers shown in Figure 2 for a given time.

Energy of mechanical origin can be supplied, for example, by exerting bending and/or tensile stresses on the remainder 21 of the nucleation substrate 2, or by introducing a blade or a jet of fluid (liquid or gas), for example, at the zone of weakness 22. Shear or ultrasound forces may also be applied.

Mechanical stresses can also result from supplying energy of electrical origin (application of an electrostatic or electromagnetic field). They can also originate from thermal energy derived from applying an electromagnetic field, an electron beam, thermoelectric heating, a cryogenic fluid, a supercooled liquid, etc. They can also be of optical origin, consisting in applying a laser beam to the zone of weakness, light absorption by the material then providing sufficient energy to generate detachment along the zone of weakness.

Energy of chemical origin may be supplied by etching in a chemical product.

Advantageously, and as shown in Figure 4, it is possible to improve the surface quality of the free surface 231 of the layer 23 to limit its residual roughness observed after the step for detaching the remainder 21. This may prove useful in ensuring the success of the subsequent steps of the method, in particular deposition of a layer by epitaxial growth.

Said reduction in roughness can be achieved by different methods such as chemico mechanical polishing, thermal oxidation followed by deoxidation (in hydrofluoric acid, for example), plasma etching, or ion beam or ion cluster smoothing.

In the particular case in which the nucleation layer 23 is silicon onto which cubic silicon carbide is to be deposited by epitaxy, it is also possible to prepare the free surface 231 using the method of forming "motifs" described in European patent EP-A-1 288 346.

The thin layers 13 and 23 are of the order of 10 nanometers (10 nm) to about 10 micrometers (10 µm) thick, and preferably are in the range from a few tens of nanometers to 1.5 micrometers (1.5 µm).

The stack of layers shown on figure 4 constitutes an epitaxy support substrate referenced 9.

The step shown in Figure 5 is optional.

It consists of forming a fine nucleation layer 5 on the thin nucleation layer 23 by epitaxy, in order to obtain an epitaxy support substrate referenced 9'.

The two above-mentioned epitaxy support substrates 9 and 9' are advantageous in that the implantation made in substrate 1 is realized before the transfer of the nucleation layer 23 so that the thin support layer 13 may be thicker as if it was done after said transfer.

Said layer 5 can be produced from the same material as that subsequently used to produce the epitaxially grown layer. It then serves as a seed for homoepitaxy, which improves the crystallographic quality of this layer.

Said fine layer 5 can also be used to compensate for differences in the expansion coefficients and lattice parameters existing between the nucleation layer 23 and the layer 6 which will subsequently be deposited by epitaxy.

Said fine layer 5 is in the range from about 200 nanometers (200 nm) to 100 micrometers (100 µm) thick.

As an example, and in particular for GaN, said fine layer 5 can be grown epitaxially by metal organic chemical vapor deposition (MOCVD), or by molecular beam epitaxy (MBE).

The fine nucleation layer 5 can also be obtained by hydride vapor phase epitaxy (HVPE), or by cathode sputtering deposition.

It is also possible to use epitaxial lateral over growth techniques, ELOG, or a technique known as "pendeoepitaxy" in which motifs are etched into the thin nucleation layer 23 before depositing the fine layer 5. Reference should be made to the article by Morgan et al, "Evaluation of GaN growth improvement techniques", Materials Science and Engineering B90 (2002), 201-205, for a description of these techniques.

The list of said techniques is not exhaustive.

The material used to produce the fine nucleation layer 5 can also be different from that used for the nucleation layer 23 and for the future epitaxially grown layer 6.

Regardless of the variant selected, i.e. whether or not the fine nucleation layer has been deposited, the material intended to form the future epitaxially grown layer 6 to be obtained is then deposited by epitaxy, either on the free surface 231 of the nucleation layer 23, or on the upper free face 50 of the fine nucleation layer 5, if present. This step is shown in Figure 6.

The epitaxially grown layer 6 can be constituted by any material that can be deposited by epitaxy, for example and preferably, large band gap semiconductors, especially gallium nitride and cubic silicon carbide.

In a first variant, said deposition is continued until the layer 6 reaches a thickness of at least 100 microns and is then self-supporting and itself constitutes a substrate which can, for example, be used in turn as a substrate for epitaxy.

Advantageously, said epitaxially grown layer 6 is obtained by a high growth rate epitaxy technique.

In the case of gallium nitride, a particularly suitable method is hydride vapor phase epitaxy (HVPE). Deposition is carried out at a temperature in the range 700°C to 1100°C.

In the case of cubic silicon carbide, one particularly suitable method is chemical vapor deposition (CVD) carried out in a cold wall CVD reactor.

For clarification, a multilayered structure can be defined with the general reference numeral 7' as comprising the thin support layer 13, the thin nucleation layer 23, the fine nucleation layer 5 and, if present, the layers of bonding boosting material 31 and 32.

When the fine nucleation layer 5 is not present, the multilayered structure has general reference numeral 7.

As shown in Figure 7, energy is supplied to the stack of layers shown in Figure 7, which is sufficient to cause detachment of the remainder 11 from the thin nucleation layer 13 along the zone of weakness 12.

This supplied energy is greater than that supplied to carry out detachment along the zone of weakness 22 of the nucleation substrate 2.

Particularly in the variant comprising the nucleation layer 5, this supplied energy is greater than the cumulative energy budget applied during detachment at the zone of weakness 22 and during epitaxial growth of the fine nucleation layer 5 and epitaxial growth of the layer 6 or 6'.

In the variant without the nucleation layer 5, it is sufficient for said supplied energy to be greater than that supplied to carry out detachment along the zone of weakness 22 of the nucleation substrate and epitaxy of the layer 6 or 6'.

Said detachment is carried out using the techniques described for detachment along the zone of weakness 22.

Finally, as shown in Figure 8, and advantageously, the multilayered structures 7 or 7' are eliminated from the epitaxially grown layer 6, for example by chemical etching, reactive ion etching (RIE) or chemico-mechanical polishing or a combination of said techniques. This results in the epitaxially grown layer 6 alone or with the fine nucleation layer 5.

In the implementation described above, the nucleation layer 23 was obtained by forming a zone of weakness in the nucleation substrate 2. However, in a further variant, not shown in the figures, the thin nucleation layer 23 can be obtained in a different manner, by bonding a substrate 2 which does not have a zone of weakness onto the support substrate 1 with or without a "bonding boosting" layer 31 and 32, then by attacking the back face 210 of said substrate 2. Attack can be carried out either by chemical etching alone or by grinding followed by chemical attack and/or ionic etching. That method is known to the skilled person as BESOI, which means "bond and etch back silicon on insulator".

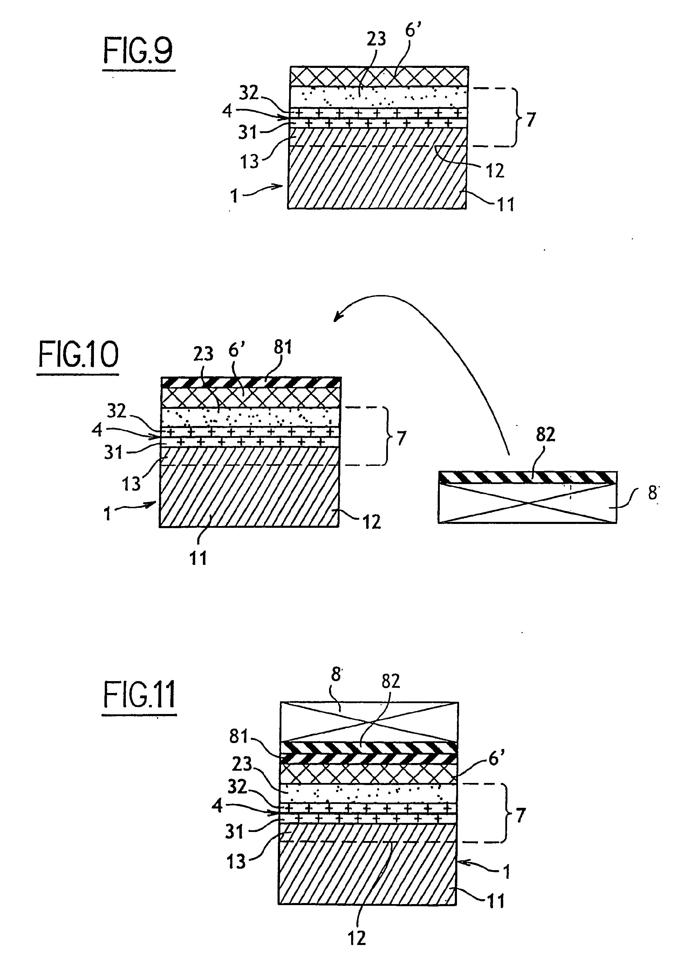

A second variant of the method is described below with reference to Figures 9 to 13.

The first steps of this method are identical to those shown in Figures 1 to 4 of the first method and are not described again.

A layer of material with reference numeral 6' is deposited by epitaxy onto the nucleation layer 23 of the stack of layers 9 shown in Figure 4.

Said epitaxially grown layer 6' is deposited using the techniques described above for the epitaxially grown layer 6, but its thickness is less than about 100 µm so that it is not self-supporting.

Deposition can be carried out by one of the techniques described in the first implementation or by metal organic chemical vapor deposition (MOCVD) or by molecular beam epitaxy (MBE).

Such a thin layer can constitute the active portion of a component and it must then be transferred to a third substrate or acceptor substrate which then becomes the mechanical support for the final component.

One example of a technique for transferring said epitaxially grown thin layer 6' is shown in Figure 10.

This is the metal bonding technique. Reference should be made, for example, to US-A-6 335 263 for a description of this technique.

Said technique consists of depositing a first layer of metal 81 on the thin epitaxially grown layer 6' and a second layer of metal 82 onto an acceptor substrate 8.

The metal layers 81 and 82 can also be replaced by multiple superimposed layers of metals and/or metal alloys.

Said metals are selected in order to obtain good bonding and/or good electrical conduction and/or to reflect light.

The metal layers 81 and 82 are then placed in contact with each other as shown in Figure 11 and the interface formed is bonded by treatment at a suitable temperature and pressure.

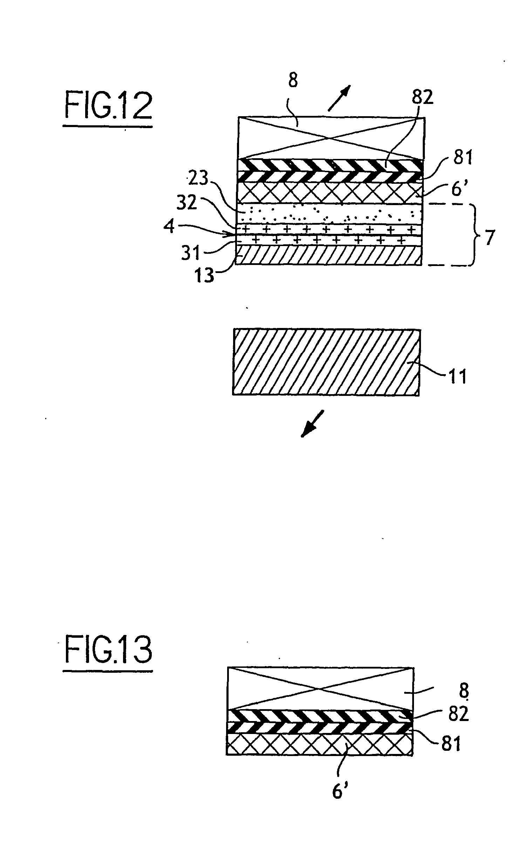

The remainder 11 is then detached from the support substrate 1 of the thin support layer 13 (see Figure 12), using the detachment techniques mentioned above for the first implementation.

Finally, as shown in Figure 13, the multilayered structure 7 is eliminated until the epitaxially grown layer 6' is obtained resting on the support 8 and capable of constituting a conducting structure.

In a variant, not shown in Figures 9 to 13, it is also possible to deposit the thin epitaxially grown layer 6' on a fine nucleation layer 5 deposited on the nucleation layer 23 using the procedures described above for the first implementation.

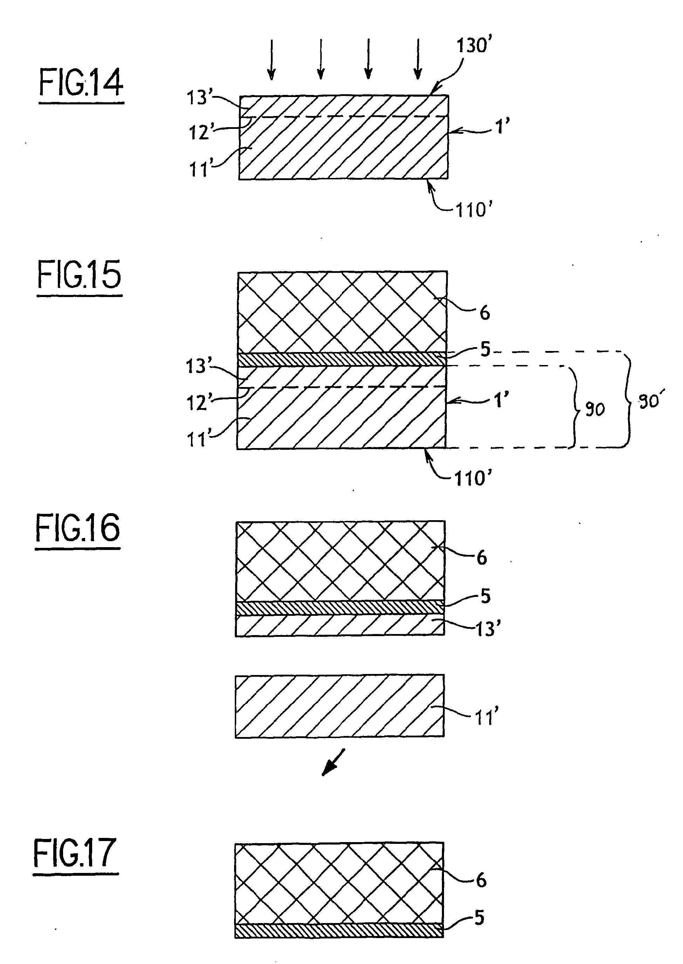

A third variant is shown in Figures 14 to 17, in which the support substrate carries the reference numeral 1' and acts both as a mechanical support and as a nucleation substrate of a nature which is suitable for subsequent epitaxial growth of the epitaxially grown layer 6 or 6'. No additional nucleation substrate 2 is used.

Atomic species implantation into said support substrate 1' is carried out to create a zone of weakness 12'. Layers which are the same as those in support substrate 1 carry the same reference numerals together with a prime.

Advantageously, the parameters for implantation are selected so that the energy budget to be supplied during detachment of the remainder 11' along the zone of weakness 12' is greater than the cumulative energy budget supplied during all of the steps preceding said detachment, in particular during the step of epitaxially growing the layer 6 or 6' and the layer 5, if present.

The epitaxy support substrate thus obtained is referenced 90 and when a fine nucleation layer 5 is present, is referenced 90'.

The thick layer 6 is then deposited in the presence or absence of a fine nucleation layer 5, see Figure 15.

It would also be possible to form a thin epitaxially grown layer 6' as above explained with the embodiment of figures 9 to 13.

Said layers 5, 6 and 6' are identical to those of the above-described embodiments and are not described again.

The remainder 11' is then detached along the zone of weakness 12' and the layer 13' is eliminated as described above, see Figures 16 and 17.

Said method can readily detach the epitaxial support from the epitaxial layer 6 or 6'.

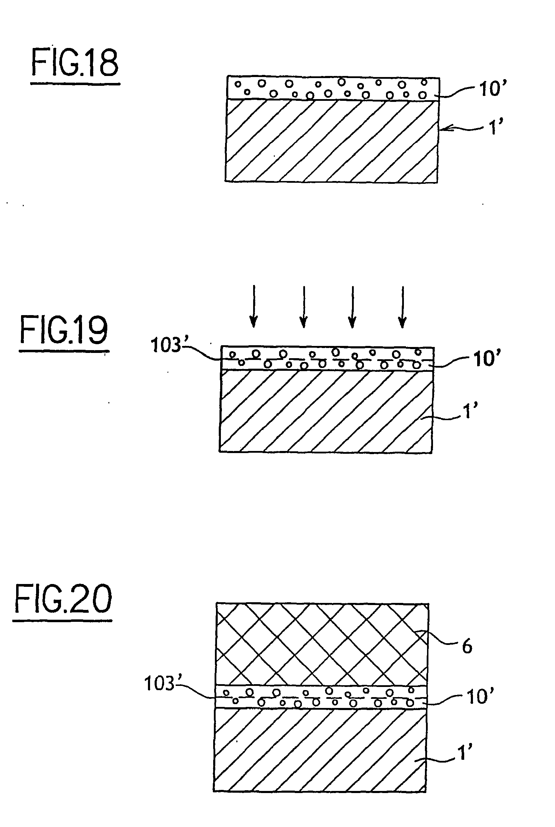

A fourth implementation is shown in Figures 18 to 22, in which the support substrate 1' is covered with an upper template layer 10'. Said template layer is obtained by the techniques described above for producing the nucleation layer 5, such as MOCVD, MBE, HVPE.

Atomic species implantation is carried out within said upper template layer 10'. The zone of weakness is shown as 103'. While not shown in the figures, implantation could also be carried out into the support substrate 1' through said template layer 10'.

Epitaxial growth of the thick 6 or thin 6' layer is then carried out (see Figure 20).

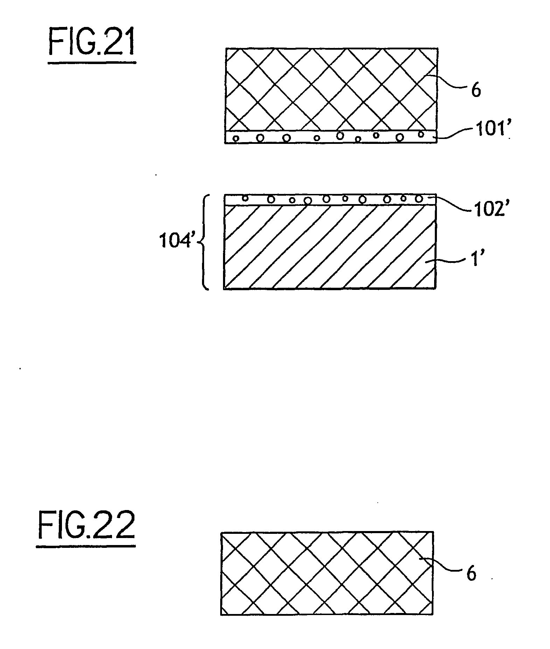

As shown in Figure 21, detachment is carried out within the template layer 10' along the zone of weakness 103' to form two layers 101' and 102'. The remainder (layer 102' and substrate 1') carries reference numeral 104'.

Clearly, the implantation parameters are selected so that the energy budget to be supplied during detachment of the remainder 104' along the zone of weakness 103' is greater than the cumulative energy budget supplied during all of the steps preceding said detachment, in particular during the step for epitaxial growth of layer 6 or 6'.

Finally, Figure 22 shows the step for eliminating the residual layer 101'. Reference in this regard can be made to the finishing steps illustrated in Figures 8 and 13.

Three examples of the method of the invention are given below.

### EXAMPLE 1: Production of a thick epitaxially grown gallium nitride layer

Hydrogen was implanted into a [111] silicon nucleation substrate 2 through a silicon oxide layer 32 obtained by thermal oxidation.

Hydrogen was also implanted onto a support substrate 1 formed from polycrystalline silicon carbide (SiC) through a layer of silicon oxide 31 obtained by deposition.

The implantation conditions for the silicon nucleation substrate 2 were an energy of 120 kilo electron-volts (keV) and a dose of 5 × 10¹⁶H⁺/cm² and for the SiC support substrate 1, the energy was 95 keV and the dose was in the range 1 × 10¹⁶H⁺/cm² to 4.5 × 10¹⁶H⁺/cm², preferably 3 × 10¹⁶H⁺/cm².

The silicon oxide layers 31 and 32 underwent chemico-mechanical polishing (CMP), to activate them and encourage their bonding by molecular bonding.

The remainder 21 of the [111] silicon layer was then detached by annealing at a temperature of 500°C for two hours. It should be noted that the thermal budget applied to ensure detachment in the silicon was less than that necessary to cause detachment in the silicon carbide so that detachment could not occur along the zone of weakness 12.

The structure obtained was then placed in a HVPE reactor and a thick layer 6 of gallium nitride (GaN) was deposited. It should be noted that the thermal budget for epitaxy (in this case several hours between 700°C and 1100°C) was less than the energy budget necessary to ensure detachment along the zone of weakness 12.

The thickness of the GaN layer measured several hundred microns.

The residue 11 was then detached by annealing at a temperature of 1300°C for 2 hours carried out in situ in the epitaxy reactor, which caused said detachment after epitaxy proper but before cooling. This avoided problems with the appearance of stresses.

Finally, the multilayered structure 7 was eliminated by chemical etching.

The resulting thick layer of GaN was of very good crystallographic quality and also had the advantage of being detached from its original substrate. Detachment was perfectly controlled and occurred only after epitaxy.

### EXAMPLE 2: Production of a thick epitaxially grown layer of monocrystalline cubic silicon carbide

Hydrogen was implanted into a monocrystalline [001] silicon nucleation substrate 2 through a silicon oxide layer 32 obtained by thermal oxidation.

Hydrogen was also implanted onto a support substrate 1 formed from polycrystalline silicon carbide (SiC) through a layer of silicon oxide 31 obtained by deposition.

The implantation conditions for the silicon nucleation substrate 2 were an energy of 120 keV and a dose of 5 × 10¹⁶H⁺/cm² and for the SiC support substrate 1, the energy was 95 keV and the dose was in the range 1 × 10¹⁶H⁺/cm² to 4.5 × 10¹⁶H⁺/cm², preferably 2 × 10¹⁶H⁺/cm².

The silicon oxide layers 31 and 32 underwent chemico-mechanical polishing (CMP), to activate them and to boost bonding by molecular bonding.

The remainder 21 from the [001] silicon layer was then detached by annealing at a temperature of 500°C for two hours. It should be noted that the thermal budget applied to ensure detachment in the silicon was less than that necessary to cause detachment in the silicon carbide, so that detachment could not occur along the zone of weakness 12.

The upper surface 231 of the [001] silicon was then prepared by chemico-mechanical polishing and by sacrificial oxidation type heat treatment or by the method of forming "motifs" described in document EP-A-1 288 346.

The structure obtained was then placed in a cold wall CVD reactor and a thick layer of cubic silicon carbide was grown epitaxially. A thick layer 6 of cubic silicon carbide several hundred microns thick was thus deposited. It should be noted that the thermal budget for epitaxy was less than the energy budget necessary to ensure detachment along the zone of weakness 12.

The remainder 11 was detached from the SiC support substrate by supplying mechanical energy after epitaxy and cooling. To this end, a blade was inserted or the structure was flexed, or a combination of the two techniques was employed.

Finally, the multilayered structure 7 was eliminated by chemical etching.

The resulting thick layer of SiC was of very good crystallographic quality. It also had the advantage of being detached from its original substrate. Detachment was perfectly controlled and occurred only after epitaxy. Further, the thick SiC layer did not have any major residual stresses since the polycrystalline SiC support substrate has the same thermal expansion characteristics as that of the epitaxially grown cubic SiC.

### EXAMPLE 3: Production of a thick epitaxially grown gallium nitride layer

Hydrogen was implanted into a monocrystalline polytype 6H (hexagonal) silicon carbide support substrate 1' through a sacrificial silicon oxide layer eliminated after implantation.

The implantation conditions were an energy in the range 50 to 200 keV, preferably 95 keV, and a dose in the range 1 × 10¹⁶H⁺/cm² to 4.5 × 10¹⁶H⁺/cm², preferably 3 × 10¹⁶H⁺/_{cm}²_{.}

A thin layer 6' of GaN was then grown epitaxially by MOCVD, said layer comprising an active zone for a light-emitting diode (LED). It should be noted that the thermal budget for said epitaxial growth (several hours of annealing between 700°C and 1100°C) was less than the energy budget necessary for subsequent detachment along the zone of weakness 12'.

The metal bonding technique described above was then used to transfer said epitaxially grown layer to an acceptor substrate 8 which can be silicon or copper.

After the bonding step, additional mechanical energy was supplied (for example by inserting a blade) to carry out detachment at the zone of weakness 12' of the support substrate 1'.

The thin support layer 13' was eliminated by chemical etching.

The SiC substrate used for epitaxial growth of an LED structure could then be removed. Detachment was perfectly controlled and occurred only after epitaxy and metal bonding.

## Claims

1. A method of fabricating an epitaxially grown layer (6, 6') in particular for applications in the fields of optics, optoelectronics, or electronics, comprising the following successive steps consisting in:
a) implanting atomic species within a first substrate (1, 1') termed the "support substrate" to define therein a zone of weakness (12, 12') which demarcates a thin layer (13, 13') termed the "thin support layer" from the remainder (11, 11') of said substrate;
b) growing said epitaxially grown layer (6, 6') by epitaxy carried out on a thin nucleation layer (23) of a nature which is suitable for subsequent epitaxial growth, said thin nucleation layer (23) having been transferred onto said thin support layer (13, 13');
c) detaching the remainder (11, 11') of the support substrate (1, 1') from the thin support layer (13, 13') along the zone of weakness (12, 12') of said support substrate by deliberately supplying an energy budget greater than the cumulative energy budget supplied during all of the steps preceding said detachment and which include the epitaxial growth of the layer (6, 6').

2. A method according to claim 1, wherein said thin nucleation layer (23) is transferred:
- by implanting atomic species within a second substrate (2) termed the "nucleation substrate" to define therein a zone of weakness (22) which demarcates said thin nucleation layer (23) from the remainder (21) of said substrate, then
- by bonding the two substrates (1, 2) either directly one against the other, or using at least one intermediate bonding layer (31, 32) so that their respective thin layers (13, 23) are located facing each other; and
- by detaching the remainder (21) of the nucleation substrate (2) along the zone of weakness (22) of said substrate (2) ;
the parameters for implantation into the support substrate (1) and into the nucleation substrate (2) being selected so that when combined with the nature of the materials constituting said two substrates, the energy budget to be supplied during detachment of the remainder (11) along the zone of weakness (12, 12') is greater than the cumulative energy budget supplied during all of the steps preceding detachment.

3. A method according to claim 2, wherein the parameters for implantation into the support substrate (1) and into the nucleation substrate (2) are selected so that, when combined with the nature of the materials constituting said two substrates, the thermal budget to be supplied during detachment of the remainder (11) along the zone of weakness (12) is greater than the cumulative thermal budget supplied during all of the steps preceding said detachment and in that the steps for detaching the remainder (11) and the remainder (12) are carried out by heating.

4. A method according to claim 2, wherein the remainder (21) of the nucleation substrate (2) or the remainder (11) of the support substrate (1) is detached by application of additional energy of mechanical, optical, and/or chemical origin.

5. A method according to claim 1, wherein said thin nucleation layer (23) is transferred:
- by bonding a second substrate (2) termed the "nucleation substrate" either directly onto said thin support layer (13), or using at least one intermediate bonding layer (31, 32);
- by reducing the thickness of said substrate (2) from its back face (210) by lapping and/or chemical etching and/or ionic etching to obtain said thin nucleation layer (23).

6. A method according to one of claims 2 to 5, wherein said intermediate bonding layer (31, 32) is a layer of dielectric material.

7. A method according to claim 6, wherein the dielectric material (31, 32) is selected from silicon oxide, silicon nitride, and silicon oxynitrides.

8. A method according to any one of claims 2 to 7, wherein bonding between the two thin layers (13, 23) either directly one against the other or in the presence of at least one intermediate bonding layer (31, 32) is molecular bonding.

9. A method according to any one of the preceding caims, wherein said thin nucleation claims, wherein said thin nucleation layer (23) is covered by a fine nucleation layer (5).

10. A method according to claim 9, wherein said fine nucleation layer (5) is produced by metal organic chemical vapor deposition (MOCVD), by hydride vapor phase epitaxy (HVPE), by molecular beam epitaxy (MBE), by cathode sputtering deposition, or by epitaxial lateral over growth (ELOG) or pendeo-epitaxy.

11. A method according to any one of the preceding claims, wherein it comprises the additional step of eliminating the thin support layer (13, 13') and the thin nucleation layer (23), the fine nucleation layer (5) or the intermediate bonding layer or layers (31, 32) remaining integral with the epitaxially grown layer (6, 6'), if present.

12. A method according to any one of the preceding claims, wherein the epitaxially grown layer (6, 6') is produced from a wide band gap semiconductor material.

13. A method according to claim 12, wherein the epitaxially grown layer (6, 6') is formed from gallium nitride.

14. A method according to claim 12, wherein the epitaxially grown layer (6, 6') is formed from cubic silicon carbide.

15. A method according to any one of the preceding claims, wherein the epitaxially grown layer (6, 6') is of sufficient thickness to constitute a self-supported layer.

16. A method according to any one of claims 1 to 14, wherein the thickness of the epitaxially grown layer (6') obtained at the end of step b) is insufficient to be self-supporting and in that the method comprises the following additional steps carried out between steps b) and c) and consisting in:
- applying a first layer of metal (81) onto said thin epitaxially grown layer (6') and a second layer of metal (82) onto a third substrate (8) termed the "acceptor substrate";
- placing the two layers of metal (81, 82) in contact with each other and bonding them together;
to obtain the thin epitaxially grown layer (6') transferred onto said acceptor substrate (8).

17. A method according to any one of the preceding claims, wherein the support substrate (1') comprises an upper template layer (10') and in that the atomic species implantation is carried out either within said support substrate (1') through said upper template layer (10') or inside said upper template layer (10'), the parameters for the implantation carried out in the support substrate (1') or in the template layer (10') being selected such that when combined with the nature of the materials constituting said substrate and said template layer, the energy budget to be supplied during detachment of the remainder (11', 104') along the zone of weakness (12', 103') is greater than the cumulative energy budget supplied during all of the steps preceding said detachment.

## Patentansprüche

1. Verfahren zur Herstellung einer epitaxial gewachsenen Schicht (6, 6'), insbesondere für Anwendungen auf den Gebieten der Optik, Optoelektronik oder Elektronik, mit den nachstehenden aufeinanderfolgenden Schritten:
a) Implantieren von Atomarten in einem "Trägersub- strat" genannten ersten Substrat (1, 1'), um darin eine Schwächezone (12, 12') zu bilden, die eine "Trägerdünnschicht" genannte Dünnschicht (13, 13') vom Rest (11, 11') des Substrats abgrenzt;
b) Wachsen der epitaxial gewachsenen Schicht (6, 6') durch Epitaxie, die auf einer Keimbildungsdünn- schicht (23) mit einer für anschließendes epitaxia- les Wachsen geeigneten Beschaffenheit durchgeführt wird, wobei die Keimbildungsdünnschicht (23) auf die Trägerdünnschicht (13, 13') übertragen wurde;
c) Ablösen des Rests (11, 11') des Trägersubstrats (1, 1') von der Trägerdünnschicht (13, 13') entlang der Schwächezone (12, 12') des Trägersubstrats durch bewusstes Zuführen eines Energiebudgets, das größer als das kumulative Energiebudget ist, das während aller Schritte zugeführt wird, die dem Ablösen vor- angehen und zu denen das epitaxiale Wachsen der Schicht (6, 6') gehört.

2. Verfahren nach Anspruch 1, wobei die Keimbildungsdünnschicht (23) übertragen wird:
- durch Implantieren von Atomarten in einem "Keimbildungssubstrat" genannten zweiten Substrat (2), um darin eine Schwächezone (22) zu bilden, die die Keimbildungsdünnschicht (23) vom Rest (21) des Substrats abgrenzt, anschließend
- durch Verbinden der beiden Substrate (1, 2) direkt miteinander oder mit Hilfe mindestens einer Zwischenverbindungsschicht (31, 32), so dass ihre jeweiligen Dünnschichten (13, 23) zueinander weisend liegen; und
- durch Ablösen des Rests (21) des Keimbildungssubstrats (2) entlang der Schwächezone (22) des Substrats (2);
wobei die Parameter für die Implantation in das Trägersubstrat (1) und in das Keimbildungssubstrat (2) so ausgewählt werden, dass in Kombination mit der Beschaffenheit der die beiden Substrate bildenden Materialien das während des Ablösens des Rests (11) entlang der Schwächezone (12, 12') zuzuführende Energiebudget größer als das kumulative Energiebudget ist, das während aller Schritte zugeführt wird, die dem Ablösen vorangehen.

3. Verfahren nach Anspruch 2, wobei die Parameter für die Implantation in das Trägersubstrat (1) und in das Keimbildungssubstrat (2) so ausgewählt werden, dass in Kombination mit der Beschaffenheit der die beiden Substrate bildenden Materialien das während des Ablösens des Rests (11) entlang der Schwächezone (12) zuzuführende Wärmebudget größer als das kumulative Wärmebudget ist, das während aller Schritte zugeführt wird, die dem Ablösen vorangehen, und wobei die Schritte zum Ablösen des Rests (11) und des Rests (12) durch Erwärmen durchgeführt werden.

4. Verfahren nach Anspruch 2, wobei der Rest (21) des Keimbildungssubstrats (2) oder der Rest (11) des Trägersubstrats (1) durch Anwendung zusätzlicher Energie mit mechanischem, optischem und/oder chemischem Ursprung abgelöst wird.

5. Verfahren nach Anspruch 1, wobei die Keimbildungsdünnschicht (23) übertragen wird:
- durch Verbinden eines "Keimbildungssubstrat" genannten zweiten Substrats (2) direkt auf die Trägerdünnschicht (13) oder mit Hilfe mindestens einer Zwischenverbindungsschicht (31, 32);
- durch Reduzieren der Dicke des Substrats (2) von seiner Rückfläche (210) aus durch Läppen und/oder chemisches Ätzen und/oder Ionenätzen, um die Keimbildungsdünnschicht (23) zu erhalten.

6. Verfahren nach einem der Ansprüche 2 bis 5, wobei die Zwischenverbindungsschicht (31, 32) eine Schicht aus dielektrischem Material ist.

7. Verfahren nach Anspruch 6, wobei das dielektrische Material (31, 32) aus Siliciumoxid, Siliciumnitrid und Siliciumoxynitriden ausgewählt wird.

8. Verfahren nach einem der Ansprüche 2 bis 7, wobei es sich beim Verbinden zwischen den beiden Dünnschichten (13, 23) direkt miteinander oder in Gegenwart mindestens einer Zwischenverbindungsschicht (31, 32) um Molekülbindung handelt.

9. Verfahren nach einem der vorstehenden Ansprüche, wobei die Keimbildungsdünnschicht (23) durch eine Keimbildungsfeinschicht (5) bedeckt wird.

10. Verfahren nach Anspruch 9, wobei die Keimbildungsfeinschicht (5) durch metallorganische chemische Gasphasenabscheidung (MOCVD), durch Hydridgasphasenepitaxie (HVPE), durch Molekularstrahlepitaxie (MBE), durch kathodische Sputterabscheidung oder durch epitaxiales laterales Wachsen (ELOG) oder Pendeo-Epitaxie erzeugt wird.

11. Verfahren nach einem der vorstehenden Ansprüche, wobei es den zusätzlichen Schritt aufweist: Eliminieren der Trägerdünnschicht (13, 13') und der Keimbildungsdünnschicht (23), wobei die Keimbildungsfeinschicht (5) oder die Zwischenverbindungsschicht oder -schichten (31, 32) bei Vorhandensein mit der epitaxial gewachsenen Schicht (6, 6') einteilig bleiben.

12. Verfahren nach einem der vorstehenden Ansprüche, wobei die epitaxial gewachsene Schicht (6, 6') aus einem Halbleitermaterial mit großem Bandabstand hergestellt wird.

13. Verfahren nach Anspruch 12, wobei die epitaxial gewachsene Schicht (6, 6') aus Galliumnitrid gebildet wird.

14. Verfahren nach Anspruch 12, wobei die epitaxial gewachsene Schicht (6, 6') aus kubischem Siliciumcarbid gebildet wird.

15. Verfahren nach einem der vorstehenden Ansprüche, wobei die epitaxial gewachsene Schicht (6, 6') ausreichende Dicke hat, um eine selbsttragende Schicht zu bilden.

16. Verfahren nach einem der Ansprüche 1 bis 14, wobei die Dicke der am Ende von Schritt b) erhaltenen epitaxial gewachsenen Schicht (6') nicht ausreicht, um selbsttragend zu sein, und wobei das Verfahren die folgenden zwischen den Schritten b) und c) durchgeführten zusätzlichen Schritte aufweist:
- Aufbringen einer ersten Metallschicht (81) auf die epitaxial gewachsene Dünnschicht (6') und einer zweiten Metallschicht (82) auf ein "Akzeptorsubstrat" genanntes drittes Substrat (8);
- Platzieren der beiden Metallschichten (81, 82) in Kontakt miteinander und Verbinden derselben miteinander;
um die epitaxial gewachsene Dünnschicht (6') zu erhalten, die auf das Akzeptorsubstrat (8) übertragen wird.

17. Verfahren nach einem der vorstehenden Ansprüche, wobei das Trägersubstrat (1') eine obere Schablonenschicht (10') aufweist und wobei die Atomartenimplantation im Trägersubstrat (1') über die obere Schablonenschicht (10') oder innerhalb der oberen Schablonenschicht (10') durchgeführt wird, wobei die Parameter für die im Trägersubstrat (1') oder in der Schablonenschicht (10') durchgeführte Implantation so ausgewählt werden, dass in Kombination mit der Beschaffenheit der das Substrat und die Schablonenschicht bildenden Materialien das während des Ablösens des Rests (11', 104') entlang der Schwächezone (12', 103') zuzuführende Energiebudget größer als das kumulative Energiebudget ist, das während aller Schritte zugeführt wird, die dem Ablösen vorangehen.

## Revendications

1. Procédé de fabrication d'une couche épitaxiée (6, 6') notamment pour des applications dans les domaines de l'optique, l'optoélectronique ou l'électronique, comprenant les étapes successives suivantes consistant à :
a) effectuer une implantation d'espèces atomiques à l'intérieur d'un premier substrat (1, 1'), dit de "support", de façon à y définir une zone de fragilisation (12, 12') qui délimite une couche mince (13, 13') dite de "support" du reste (11, 11') de ce substrat,
b) faire croître ladite couche épitaxiée (6, 6') par une épitaxie effectuée sur une couche mince de nucléation (23) dont la nature est appropriée à la croissance ultérieure, ladite couche mince de nucléation (23) ayant été transférée sur ladite couche mince de support (13, 13'),
c) détacher le reste (11, 11') du substrat support (1, 1') de la couche mince de support (13, 13'), le long de la zone de fragilisation (12, 12') de ce substrat support, par un apport volontaire d'un budget énergétique supérieur au budget énergétique cumulé apporté lors de toutes les étapes qui précèdent ce détachement et qui incluent la croissance épitaxiale de la couche (6, 6').

2. Procédé selon la revendication 1, dans lequel ladite couche mince de nucléation (23) est reportée :
- en réalisant une implantation d'espèces atomiques à l'intérieur d'un deuxième substrat (2) dit "de nucléation" de façon à y définir une zone de fragilisation (22) qui délimite ladite couche mince de nucléation (23) du reste (21) de ce substrat (2), ensuite
- en collant les deux substrats (1, 2) soit directement l'un contre l'autre, soit à l'aide d'au moins une couche intermédiaire de collage (31, 32), de façon que leurs couches minces respectives (13, 23) soient situées en regard l'une de l'autre, et
- en procédant au détachement du reste (21) du substrat de nucléation (2) le long de la zone de fragilisation (22) dudit substrat (2),
les paramètres des implantations réalisées dans le substrat support (1) et dans le substrat de nucléation (2) étant choisis de façon telle que combinés à la nature des matériaux constituant ces deux substrats, le budget énergétique à apporter lors du détachement du reste (11) le long de la zone de fragilisation (12, 12') soit supérieur au budget énergétique cumulé apporté lors de toutes les étapes qui précèdent ce détachement.

3. Procédé selon la revendication 2, dans lequel les paramètres des implantations réalisées dans le substrat support (1) et dans le substrat de nucléation (2) sont choisis de façon telle que combinés à la nature des matériaux constituant ces deux substrats, le budget thermique à apporter lors du détachement du reste (11) le long de la zone de fragilisation (12) soit supérieur au budget thermique cumulé apporté lors de toutes les étapes qui précèdent ce détachement et en ce que les étapes de détachement du reste (11) et du reste (21) sont effectuées par chauffage.

4. Procédé selon la revendication 2, dans lequel le détachement du reste (21) du substrat de nucléation (2) ou le détachement du reste (11) du substrat de support (1) est effectué par application d'un apport d'énergie d'origine mécanique, optique et/ou chimique.

5. Procédé selon la revendication 1, dans lequel ladite couche mince de nucléation (23) est reportée :
- en collant un deuxième substrat (2) dit "de nucléation" soit directement sur ladite couche mince de support (13), soit à l'aide d'au moins une couche intermédiaire de collage (31, 32),
- en diminuant l'épaisseur de ce substrat (2) depuis sa face arrière (210) par rodage et/ou gravure chimique et/ou gravure ionique jusqu'à obtenir ladite couche mince de nucléation (23).

6. Procédé selon l'une des revendications 2 à 5, dans lequel la couche intermédiaire de collage (31, 32) est une couche de matériau diélectrique.

7. Procédé selon la revendication 6, dans lequel le matériau diélectrique (31, 32) est choisi parmi l'oxyde de silicium, le nitrure de silicium et les oxynitrures de silicium.

8. Procédé selon l'une quelconque des revendications 2 à 7, dans lequel le collage entre les deux couches minces (13, 23) soit directement l'une contre l'autre, soit en présence d'au moins une couche intermédiaire de collage (31, 32) est un collage par adhésion moléculaire.

9. Procédé selon l'une quelconque des revendications précédentes, dans lequel ladite couche mince de nucléation (23) est recouverte par une couche fine de nucléation (5).

10. Procédé selon la revendication 9, dans lequel ladite couche fine de nucléation (5) est réalisée par dépôt chimique en phase vapeur d'organométalliques (MOCVD), par épitaxie en phase vapeur d'hydrure (HVPE), par épitaxie par jet moléculaire (MBE), par dépôt par pulvérisation cathodique ou par des méthodes de croissance latérale par épitaxie (ELOG) ou de pendéo-épitaxie.

11. Procédé selon l'une quelconque des revendications précédentes, qui comprend l'étape supplémentaire d'élimination de la couche mince de support (13, 13'), de la couche mince de nucléation (23), de la couche fine de nucléation (5) ou de la ou des couches de collage intermédiaire (31, 32) restées solidaires de la couche épitaxiée (6, 6'), si elles sont présentes.

12. Procédé selon l'une quelconque des revendications précédentes, dans lequel la couche épitaxiée (6, 6') est réalisée dans un matériau semi-conducteur à large bande interdite.

13. Procédé selon la revendication 12, dans lequel la couche épitaxiée (6, 6') est en nitrure de gallium.

14. Procédé selon la revendication 12, dans lequel la couche épitaxiée (6, 6') est en carbure de silicium cubique.

15. Procédé selon l'une quelconque des revendications précédentes, dans lequel la couche épitaxiée (6) est d'une épaisseur suffisante pour constituer une couche autoportée.

16. Procédé selon l'une quelconque des revendications 1 à 14, dans lequel la couche épitaxiée (6') obtenue à l'issue de l'étape b) est d'une épaisseur insuffisante pour être autoportée et en ce que le procédé comprend les étapes supplémentaires suivantes effectuées entre les étapes b) et c) et consistant à :
- appliquer une première couche de métal (81) sur ladite couche mince épitaxiée (6') et une seconde couche de métal (82) sur un troisième substrat (8) dit "substrat d'accueil",
- placer les deux couches de métal (81, 82) au contact l'une de l'autre et effectuer leur collage,
de façon à obtenir la couche épitaxiée mince (6') reportée sur ledit substrat d'accueil (8).

17. Procédé selon l'une quelconque des revendications précédentes, dans lequel le substrat support (1') comprend une couche supérieure d'amorce (10') et en ce que l'implantation d'espèces atomiques est effectuée soit à l'intérieur dudit substrat support (1') à travers cette couche supérieure d'amorce (10'), soit à l'intérieur même de ladite couche supérieure d'amorce (10'), les paramètres de l'implantation réalisée dans le substrat support (1') ou dans la couche d'amorce (10') étant choisis de façon telle que combinés à la nature des matériaux constituant ce substrat et cette couche d'amorce, le budget énergétique à apporter lors du détachement du reste (11',104') le long de la zone de fragilisation (12',103') soit supérieur au budget énergétique cumulé apporté lors de toutes les étapes qui précèdent ce détachement.
